Europäisches Patentamt

European Patent Office

Office européen des brevets

(19)

(11) Publication number: **0 047 456**
**B1**

(12) # EUROPEAN PATENT SPECIFICATION

(45) Date of publication of patent specification: **25.07.84**    (51) Int. Cl.³: **C 23 C 15/00**

(21) Application number: **81106756.0**

(22) Date of filing: **29.08.81**

(54) **Ion plating without the introduction of gas.**

(30) Priority: **08.09.80 JP 124409/80**

(43) Date of publication of application:
**17.03.82 Bulletin 82/11**

(45) Publication of the grant of the patent:
**25.07.84 Bulletin 84/30**

(84) Designated Contracting States:
**CH DE FR GB IT LI NL SE**

(56) References cited:
**US - A - 4 038 171**
**US - A - 4 043 889**

(73) Proprietor: **Wada, Ayao**
**3-6-52 Kitashinagawa Shinagawa-ku**
**Tokyo (JP)**

(72) Inventor: **Wada, Ayao**
**3-6-52 Kitashinagawa Shinagawa-ku**
**Tokyo (JP)**

(74) Representative: **Patentanwälte Kohler -**
**Schwindling - Späth**
**Hohentwielstrasse 41**
**D-7000 Stuttgart 1 (DE)**

## Description

Background of the Invention
1. *Field of the Invention:*

This invention relates to a process for ion plating a substrate held within a vacuum chamber in the absence of any gas, inert or othrewise.

2. *Brief Description of the Prior Art:*

In the past, substrates have been plated using vacuum evaporation methods, sputtering, and ion plating with an argon plasma. All of these methods have some inherent disadvantages. The vacuum evaporation system deposits materials on substrates without particle acceleration resulting in a bond between the coating and the substrate of poor adhesive strength so that the coating may be easily separated from the substrate. Because of the deposition path of the evaporated material in an evaporation technique, uniform thickness on an irregularly shaped part is difficult to achieve. Sputtering methods overcome some of the problems of vapor deposition in that better adhesion of the plating material to the substrate is achieved. However, the energy levels of the plating atom to be deposited is such that the adhesive strength of the bond is not adequate for many applications. The sputtering process is dependent upon an ion of inert gas impinging upon the plating material to release an atom of plating material. The plating material is at a neutral electrical charge and must travel through the inert gas plasma and on to the substrates.

In travelling through the inert gas plasma, the plating atom will strike inert gas atoms thus losing energy.

This loss of energy results in a relatively low energy deposition force on to the substrate and possible contamination of the plated surface by inert gas atoms becoming entrapped in the plating material.

Ion plating with an inert gas plasma overcomes some of the problems of uniformity in the plating layer and develops better bond strength.

Because of the entrapment of the inert gas the coating may be contaminated with the inert gas atoms resulting in a film composition that is not suitable for many applications, especially in electronics.

Summary of the Invention

Generally, this invention would be composed of a vacuum plating system with the high rate ion source for converting the material to be plated onto the substrate into the plasma form in the area of the substrate.

One of the objects of the present invention is to provide the ion plating process for plating both conductive and non conductive substrates with a wide variety of materials at high deposition rates.

Another object of the present invention is to provide the ion plating process that will plate such wide varieties of material whether such material is flat, irregularly shaped with irregular depressions, raised surfaces or holes, and to provide unbroken coating surface over such irregularities or into the internal diameters of holes.

A further object of the present invention is to provide the plating system not dependent upon the inert gas plasma to achieve the plating thereby giving a contamination free plating surface consisting solely of the plating material.

A still further object of the present invention is to provide the high energy plating ion impact with the substrate to achieve an atomic bonding of the plating material with the substrate.

These objects are met by a process comprising either the steps of
   a. evacuating the vacuum chamber,
   b. vaporizing from a vapor source the material to be plated,
   c. applying a radio frequency field from a radio frequency power supply to the substrate to ionize the plating material that has been vaporized,
   d. applying a negative electrical bias of direct current voltage from a direct current power supply on such substrate thereby creating a negative charge on the substrate to attract positive ions of plating material;
   or the steps of
   a. evacuating the vacuum chamber,
   b. vaporizing from a vapor source the material to be plated,
   c. applying a radio frequency field from a radio frequency power supply to the vapor source to form positive ions of vaporized material,
   d. applying a direct current positive bias from a direct current power supply to the vapor source to accelerate positive ions of plating material away from the source to the substrate.

The specific manner of performing the intent of the invention is shown in drawings that are part of this application.

Brief Description of the Drawings

Figures 1, 2, and 3 are schematic systems of the vacuum ion plating system constructed to perform the requirements and objects of this plating invention.

Fig. 4 is an enlarged fragmentary view of vapor source of the system of Fig. 3.

Detailed Description of the Preferred Embodiments of the Invention

The drawings show the electrical arrangement for material vaporization, ionization and substrate plating.

All of the plating system is enclosed in a tank (1) to provide a vacuum enclosure, the tank having a working vacuum seal (2) and electrical feedthroughs (3) some or all of which may be made removable from the body of the system (4).

The tank may be vertical or horizontal, or at any other angle that may be convenient and may be made in different shapes from different materials. The baseplate (29) of tank (1) has provisions for passing through the electrical wires, the gas line (5) and vacuum evacuation connection (6) so that when the chamber is closed the internal portion can be environmentally controlled.

The substrate (7) is supported by a base or fixture (8) which may be shaped in any configuration. The holding fixture (8) may be fixed or movable during the plating operation without departing from the principles of this invention. The ion plating source (9) may be a filament, a refractory boat, an electron beam gun, an induction heated crucible, or any other material vaporization source or multiples of the same that may be utilized to vaporize plating material without departing from the principles of this invention. A gas supply tube (5) is passed through the system wall or other convenient location and input gas is controlled by a metering valve (10). The input gas may be inert or other gases or combinations thereof, conducive to performing specific functions such as but not limited to cleaning of the substrate prior to the plating operation. A vacuum pumping system is connected through a valve (6) to the system through a baseplate or chamber (1) by a sealed passage (11) in the baseplate (29) or chamber (1). The radio frequency power supply (12) and the direct current power supply (13) transmit power to the ion plating source (9) (8) through the feedthrough connectors (3 and 3') in the baseplate (29) or chamber (1).

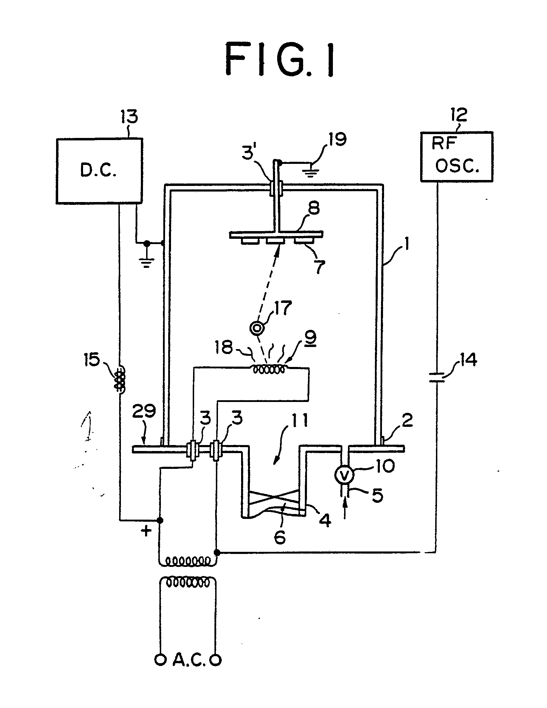

The sequence of operations of the plating system is as follows; The system is evacuated by use of a vacuum system through the sealed passage (11). If it is desired to have a cleaning procedure for the substrate, such gas can be admitted to the chamber through the gas supply tube (5) and the valve (10). If desired for cleaning, a plasma can be formed by the gas to bombard the surface of the substrate. After such cleaning, the argon or other gas is withdrawn from the evacuated enclosure prior to the beginning of the plating process. Figure 1 shows one mode of operation where, after withdrawing the argon or other gas, radio frequency power from the radio frequency power supply (12), mixed with direct current positive bias from the direct current power supply (13) is supplied to the vaporization or sublimation source (9) to form positive ions of the evaporated material and accelerated those positive ions toward the substrate by repulsion from the positive bias on the source. The radio frequency and the direct current power supplies are protected from each other by inserting a radio frequency capacitor (14) and a radio frequency choke (15) in the outline lines. Plating begins when the material source (9) is heated to a temperature high enough to vaporize or sublimate the plating material. In the case of resistance heated sources, this is normally done by a low voltage, high current alternating current supply (A.C.)

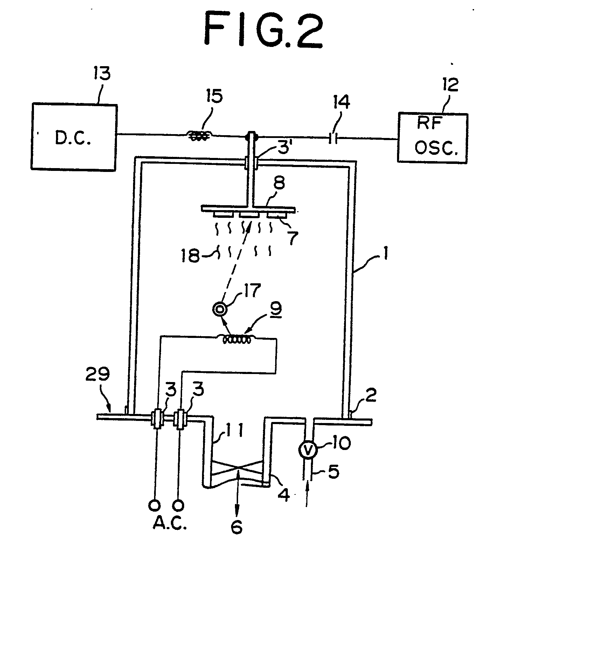

The substrate (7) may be at ground potential (19) as shown in figure 1. In another configuration, figure 2 the substrate (7) by means of electrical connections to the holder that supports it, has both radio frequency and negative direct current applied to it. In this case, the atoms of evaporant material (17) from the vaporization or sublimation source are positively ionized by the action of the radio frequency field (18) and are attracted by electrostatic force to the substrate by the negative direct current. If the substrate is a nonconductor, the radiation of the radio frequency field will cause it to develop a sustained negative charge on its surface. This is known as radio frequency "self bias" effect and serves to attract the positive ions of plating material which makes it possible to plate insulators by this method.

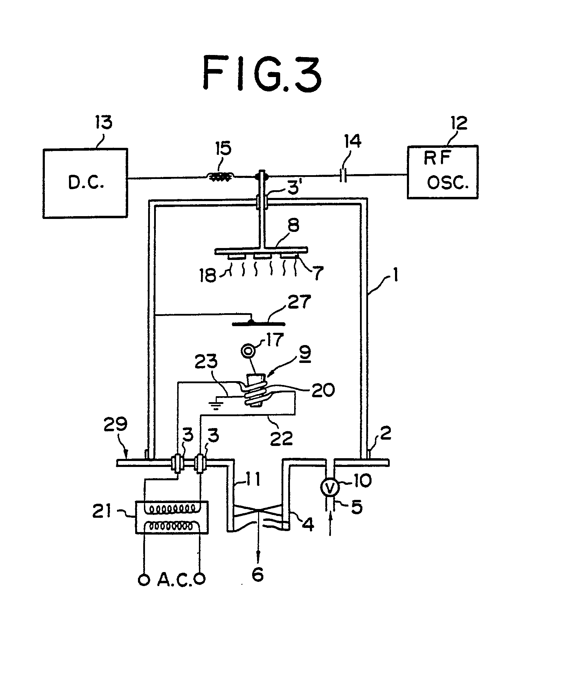

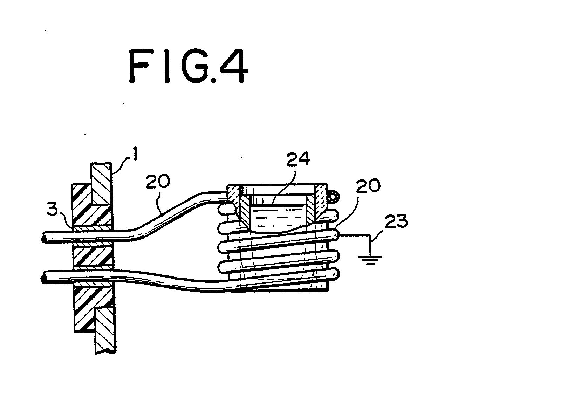

Still another way to achieve ionization during the vaporization or sublimation of the plating material is to use an induction coil as shown in figures 3 and 4. The expanding and collapsing field in an induction coil (20) will cause all susceptive materials to heat as well as to release electrons from vaporized or sublimated atoms to form positive ions. Coil frequencies may vary, with higher frequencies usually improving both heating and ionization, the range of frequencies normally being above 10 kHz. The problems of low impedance arcing which may occur at higher frequencies can be eliminated by the use of a coupling transformer (21). When using such a source in most applications it is advantageous to have both radio frequency and direct current biasing on the substrate as the additional radio frequency field will increase the degree of vapor or sublimation ionization which improves the uniformity of the deposited film.

The frequency of the radio frequency biasing signal, whether it be on the source or substrate, may range from 5 kHz to over 20 MHz. Energy savings can be achieved by using a ceramic crucible (25) inside a nonsusceptive heat shield. This allows for radio frequency heating of the source material while retaining the heat input by the resistance to heat transfer of the insulating materials.

The ion plating material is vaporized, or sublimated, then ionized (17) to form a pure plasma of plating material. The ion plasma conforms to the configuration of the charged substrate giving coverage for irregularly shaped surfaces such as steps, curves and the inside of holes. Thus the radio frequency field causes the material to be deposited to impact with the substrate surface at very high energy levels creating excellent adhesion between the plating material and the substrate. When extremely sensitive substrates are to be coated a fixed or movable baffle (27 of figure 3) may be inserted for radiation protection without detracting from the quality of the coating. The fixed or movable baffle may also be used to prevent or reduce the possibility of deposition of unwanted deposits of less than pure material that may be formed initially at the beginning of the vaporization or sublimation process of the material to be deposited. The foregoing description of the process does not require the addition of any gas or vapor from an outside source for ionization to take place. It is recognized that with some materials to be ionized there may be gas released when the material to be evaporated or sublimated is changed to its ionized state.

While the invention is described as fully as possible with various configurations and conditions described herein, there are various changes and configurations that may be incorporated without deviation from the basic principles shown herein.

## Claims

1. A process for ion plating a substrate (7) held within a vacuum chamber (1) in the absence of any gas, inert or otherwise, such process comprising the steps of:
   a. evaporating the vacuum chamber (1),
   b. vaporizing from a vapor source (9) the material (17) to be plated,
   c. applying a radio frequency field (18) from a radio frequency power supply (12) to the substrate (7) to ionize the plating material that has been vaporized,
   d. applying a negative electrical bias of direct current voltage from a direct current power supply (13) on such substrate (7) thereby creating a negative charge on the substrate (7) to attract positive ions of plating material (17).

2. A process for ion plating a substrate (7) held within a vacuum chamber (1) in the absence of any gas, inert or otherwise, such process comprising the steps of:
   a. evacuating the vacuum chamber (1),
   b. vaporizing from a vapor source (9) the material (17) to be plated,
   c. applying a radio frequency field (18) from a radio frequency power supply (12) to the vapor source (9) to form positive ions of vaporized material,
   d. applying a direct current positive bias from a direct current power supply (13) to the vapor source (9) to accelerate positive ions of plating material away from the source (9) to the substrate (7).

3. The ion plating process of claim 1 or 2 where the substrate (7) is a conductor.

4. The ion plating process of claim 1 or 2 where the substrate (7) is an insulator.

5. The ion plating process of claim 1 or 2 where the vapor source (9) is an induction coil (20) capable of generating ions of evaporant material.

6. The ion plating process of claim 1 or 2 where the substrate (7) is baffled from the vapor source (9).

7. The ion plating process of Claim 1 or 2 where the radio frequency power supply (12) is protected from direct current and voltage by a radio frequency blocking capacitor (14) inserted in its output lines.

8. The ion plating process of claim 1 or 2 where the direct current power supply (13) is protected by a radio frequency choke (15) inserted in its output lines.

## Revendications

1. Procédé de placage ionique d'un substrat (7) maintenu à l'intérieur d'une chambre à vide (1) en l'absence de tout gaz, inerte ou autre, ce procédé comprenant les opérations suivantes:
   a. faire le vide dans la chambre à vide (1),
   b. vaporiser, à partir d'une source de vapeur (9), le matériau (17) à plaquer,
   c. appliquer un champ de haute fréquence (18) au substrat (7) à partir d'une alimentation électrique de haute fréquence (12) afin d'ioniser le matériau de placage qui a été vaporisé,
   d. appliquer une tension continue négative de polarisation, en provenance d'une alimentation électrique en courant continu (13), au substrat (7) afin de créer sur le substrat (7) une charge négative destinée à attirer les ions positifs du matériau de placage (17).

2. Procédé de placage ionique d'un substrat (7) maintenu à l'intérieur d'une chambre à vide (1) en l'absence de tout gaz, inerte ou autre, ce procédé comprenant les opérations suivantes:
   a. faire le vide dans la chambre à vide (1),
   b. vaporiser, à partir d'une source de vapeur (9), le matériau (17) à plaquer,
   c. appliquer un champ de haute fréquence (18) a la source de vapeur (9) à partir d'une alimentation électrique de haute fréquence (12) afin de former des ions positifs du matériau vaporisé,
   d. appliquer une tension continue positive de polarisation à la source de vapeur (9) à partir d'une alimentation électrique en courant continu (13) afin d'accélérer les ions positifs du matériau de placage allant de la source (9) au substrat (7).

3. Procédé de placage ionique selon la revendication 1 ou 2, où le substrat (7) est un conducteur.

4. Procédé de placage ionique selon la revendication 1 ou 2, où le substrat (7) est un isolant.

5. Procédé de placage ionique selon la revendication 1 ou 2, où la source de vapeur (9) est une bobine d'induction (20) permettant de produire des ions du matériau se vaporisant.

6. Procédé de placage ionique selon la revendication 1 ou 2, où le subsrat (7) est protégé de la source de vapeur (9) par un déflecteur.

7. Procédé de placage ionique selon la revendication 1 ou 2, où l'alimentation électrique de haute fréquence (12) est protégée du courant continu et de la tension continue par un condensateur (14) de blocage de la haute fréquence qui est inséré dans ses lignes de sortie.

8. Procédé de placage ionique selon la revendication 1 ou 2, où l'alimentation en courant continu (13) est protégée par une bobine de choc (15) puor haute fréquence qui est insérée dans ses lignes de sortie.

## Patentansprüche

1. Verfahren zum Ionenplattieren eines innerhalb einer Vakuumkammer (1) gehaltenen Substrats (7) ohne Zuführen eines inerten oder Sonstigen Gases, gekennzeichnet durch die folgenden Schritte:
   a) Evakuieren der Vakuumkammer (1)
   b) Verdampfen des Plattierungsmaterials (17) von einer Dampfquelle (9),
   c) Anlegen eines Hochfrequenzfeldes (18) an das Substrat (7) mittels einer Hochfrequenz-Energiequelle (12) zum Ionisieren des verdampften Plattierungsmaterials,
   d) Anlegen einer negativen elektrischen Gleichspannung mittels einer Gleichstrom-Energiequelle (13) an das Substrat (7), um dadurch auf dem Substrat (7) eine negative Ladung zu erzeugen und positive Ionen des Plattierungsmaterials (17) anzuziehen.

2. Verfahren zum Ionenplattieren eines innerhalb einer Vakuumkammer (1) gehaltenen Substrats (7) ohne Zuführen eines inerten oder sonstigen Gases, gekennzeichnet durch die folgenden Schritte:
   a) Evakuieren der Vakuumkammer (1),
   b) Verdampfen des Plattierungsmaterials (17) von einer Dampfquelle (9),
   c) Anlegen eines Hochfrequenzfeldes (18) and die Dampfquelle (9) mittels einer Hochfrequenz-Energiequelle (12) zur Bildung von positiven Ionen aus verdampftem Material,
   d) Anlegen einer positiven elektrischen Gleichspannung mittels einer Gleichstrom-Energiequelle (13) an die Dampfquelle (9), um dadurch positive Ionen des Plattierungsmaterial von der Quelle (9) weg und hin zum Substrat (7) zu beschleunigen.

3. Verfahren zum Ionenplattieren nach Anspruch 1 oder 2, dadurch gekennzeichnet, daß das Substrat (7) ein elektrischer Leiter ist.

4. Verfahren zum Ionenplattieren nach Anspruch 1 oder 2, dadurch gekennzeichnet, daß das Substrat (7) ein Isolator ist.

5. Verfahren zum Ionenplattieren nach Anspruch 1 oder 2, dadurch gekennzeichnet, daß die Dampfquelle (9) eine Induktionsspule ist, die in der Lage ist, Ionen des zu verdampfenden Materials zu erzeugen.

6. Verfahren zum Ionenplattieren nach Anspruch 1 oder 2, dadurch gekennzeichnet, daß das Substrat (7) gegenüber der Dampfquelle (9) abgeschirmt ist.

7. Verfahren zum Ionenplattieren nach Anspruch 1 oder 2, dadurch gekennzeichnet, daß die Hochfrequenz-Energiequelle (12) gegen Gleichstrom und Gleichspannung durch einen Hochfrequenz-Sperrkondensator (14) geschützt ist, der in die Ausgangsleitungen der geschützt ist, der in die Ausgangsleitungen der Hochfrequenz-Energiequelle eingeschaltet ist.

8. Verfahren zum Ionenplattieren nach Anspruch 1 oder 2, dadurch gekennzeichnet, daß die Gleichstrom-Energiequelle (13) durch eine in ihre Ausgangsleitungen eingeschaltete Hochfrequenzdrossel (15) geschützt ist.

# FIG. 1

# FIG.2

# FIG.3

# FIG.4